# EUROPÄISCHE PATENTSCHRIFT

(11) **EP 0 776 916 B1**
(45) Veröffentlichungstag und Bekanntmachung des Hinweises auf die Patenterteilung: **21.03.2001**
(21) Anmeldenummer: 96118614.5
(22) Anmeldetag: 20.11.1996
(51) Int. Cl.: C08F 290/00, C08F 210/14

(54) **Strahlungshärtbare Zusammensetzung enthaltend alpha-Olefine**
Photocurable composition comprising alpha-olefins
Composition photodurcissable comprenant des alpha-oléfines

(30) Priorität: 29.11.1995 DE 19544493
(43) Veröffentlichungstag der Anmeldung: 04.06.1997
(73) Patentinhaber: BASF AKTIENGESELLSCHAFT, 67056 Ludwigshafen (DE)
(72) Erfinder: Häussling, Lukas, Dr., 67098 Bad Dürkheim (DE); Bernhard, Ludwig, 64646 Heppenheim (DE); Reich, Wolfgang, Dr., 67133 Maxdorf (DE); Schwalm, Reinhold, Dr., 67157 Wachenheim (DE); Beck, Erich, Dr., 68528 Ladenburg (DE); Hartmann, Gabriele, 68766 Hockenheim (DE)

(56) Entgegenhaltungen:
- DE-A- 3 329 877
- US-A- 5 202 361
- PATENT ABSTRACTS OF JAPAN vol. 009, no. 145 (C-287), 20. Juni 1985 & JP 60 027628 A (SHOWA DENKO KK), 12. Februar 1985

## Beschreibung

Die Erfindung betrifft strahlungshärtbare Zusammensetzungen auf Basis von strahlungshärtbaren, radikalisch polymerisierbaren Verbindungen, enthaltend 0,1 bis 10 Gew.-% α-Olefine mit mehr als 8 C-Atomen, bezogen auf die Gesamtmenge an radikalisch polymerisierbaren Verbindungen.

Des weiteren betrifft die Erfindung ein Verfahren zur Herstellung von Formkörpern oder Beschichtungen, welche durch ein solches Verfahren erhältlich sind.

Bei der Stahlungshärtung von radikalisch polymerisierbaren Verbindungen, z.B. von (Meth)acrylatverbindungen kann eine starke Inhibierung der Polymerisation bzw. Härtung durch Sauerstoff, insbesondere an der Oberfläche auftreten. Diese Inhibierung führt zu einer unvollständigen Härtung in der Oberfläche und so z.B zu klebrigen Beschichtungen. Vielfältig ist daher der Ausschluß von Luftsauerstoff erforderlich, um mit der Inhibierung verbundene Nachteile zu vermeiden.

Aus DE-A-19 56 376 ist bekannt, die Inhibierung durch Sauerstoff bei der Stahlungshärtung durch Auftragen von Paraffinen, Wachsen oder Polyolefinen auf den zu härtenden Lackfilm zu vermindern. Für den gleichen Zweck sind in DE-A-33 29 877 niedermolekulare Olefine und Polyolefine beschreiben.

Die bisherigen Verfahren zur Verminderung der Sauerstoffinhibierung zeigen noch keine ausreichende Wirkung. Insbesondere ist auch nachteilig, daß die nach der Strahlungshärtung erhaltenen Oberflächen matt sind.

Aufgabe der vorliegenden Erfindung waren daher strahlungshärtbare Zusammensetzungen auf Basis radikalisch polymerisierbarer Verbindungen, deren Polymerisation bzw. Härtung nicht oder zumindest in deutlich verringertem Ausmaß durch Sauerstoff inhibiert wird und die nach der Strahlungshärtung eine glänzende Oberfläche aufweisen.

Demgemäß wurden die eingangs definierten strahlungshärtbaren Zusammensetzungen gefunden.

Bei den strahlungshärtbaren, radikalisch polymerisierbaren Verbindungen handelt es sich insbesondere um radikalisch polymerisierbare Verbindungen mit mindestens 2 copolymerisierbaren, ethylenisch ungesättigten Gruppen (Verbindungen a). Bevorzugt handelt es sich bei mindestens 50 Gew.-%, besonders bevorzugt mindestens 80 Gew.-% der strahlungshärtbaren, radikalisch polymerisierbaren Verbindungen um Verbindungen a).

Bevorzugte Verbindungen a) enthalten 2 bis 20, bevorzugt 2 bis 10 und ganz besonders bevorzugt 2 bis 6 copolymerisierbare, ethylenisch ungesättigte Doppelbindungen.

Insbesondere handelt es sich bei Verbindungen a) um (Meth)acrylatverbindungen, bevorzugt sind jeweils die Acrylatverbindungen, d.h. die Derivate der Acrylsäure.

Bevorzugt sind strahlungshärtbare Zusammensetzungen, wobei es sich bei mindestens 50 Gew.-% der strahlungshärtbaren, radikalisch polymerisierbaren Verbindungen um (Meth)acrylatverbindungen mit zwei oder mehr (Meth)acrylgruppen handelt.

Das zahlenmittlere Molekulargewicht Mₙ der Verbindungen a), insbesondere der (Meth)acrylatverbindungen liegt bevorzugt unter 15000, besonders bevorzugt unter 5000, ganz besonders bevorzugt unter 3000 g/mol und über 180 g/mol (bestimmt durch Gelpermeationschromatographie mit Polystyrol als Standard und Tetrahydrofuran als Elutionsmittel).

Als (Meth)acrylatverbindungen genannt seien (Meth)acrylsäureester und insbesondere Acrylsäureester von mehrfunktionellen Alkoholen, insbesondere solchen, die neben den Hydroxylgruppen keine weiteren funktionellen Gruppen oder allenfalls Ethergruppen enthalten. Beispiele solcher Alkohole sind z.B. bifunktionelle Alkohole, wie Ethylenglykol, Propylenglykol, und deren höher kondensierte Vertreter, z.B. wie Diethylenglykol, Triethylenglykol, Dipropylenglykol, Tripropylenglykol etc., Butandiol, Pentandiol, Hexandiol, Neopentylglykol, alkoxylierte phenolische Verbindungen, wie ethoxylierte bzw. propoxylierte Bisphenole, Cyclohexandimethanol, trifunktionelle und höherfunktionelle Alkohole, wie Glycerin, Trimethylolpropan, Butantriol, Trimethylolethan, Pentaerythrit, Ditrimethylolpropan, Dipentaerythrit, Sorbit, Mannit und die entsprechenden alkoxylierten, insbesondere ethoxy- und propoxylierte Alkohole.

Die Alkoxylierungsprodukte sind in bekannter Weise durch Umsetzung der vorstehenden Alkohole mit Alkylenoxiden, insbesondere Ethylen- oder Propylenoxid, erhältlich. Vorzugsweise beträgt der Alkoxylierungsgrad je Hydroxylgruppe 0 bis 10, d.h. 1 mol Hydroxylgruppe kann vorzugsweise mit bis zu 10 mol Alkylenoxiden alkoxyliert sein.

Als (Meth)acrylatverbindungen seien weiterhin Polyester(meth)acrylate genannt, wobei es sich um die Acrylsäureester von Polyesterolen handelt.

Als Polyesterole kommen z.B. solche in Betracht, wie sie durch Veresterung von Polycarbonsäuren, vorzugsweise Dicarbonsäuren, mit Polyolen, vorzugsweise Diolen, hergestellt werden können. Die Ausgangsstoffe für solche hydroxylgruppenhaltige Polyester sind dem Fachmann bekannt. Bevorzugt können als Dicarbonsäuren Bernsteinsäure, Glutarsäure, Adipinsäure, Sebacinsäure, o-Phthalsäure, deren Isomere und Hydrierungsprodukte sowie veresterbare Derivate, wie Anhydride oder Dialkylester der genannten Säuren eingesetzt werden. Als Polyole kommen die oben genannten Alkohole, vorzugsweise Ethylenglykol, Propylenglykol-1,2 und -1,3, Butandiol-1,4, Hexandiol-1,6, Neopentylglykol, Cyclohexandimethanol sowie Polyglykole vom Typ des Ethylenglykols und Propylenglykols in Betracht.

Polyester(meth)acrylate können in mehreren Stufen oder auch einstufig, wie z.B. in EP 279 303 beschrieben, aus Acrylsäure, Polycarbonsäure, Polyol hergestellt werden.

Weiterhin kann es sich bei Verbindungen a) z.B. um Epoxid- oder Urethan (meth)acrylate handeln.

Epoxid(meth)acrylate sind z.B. solche wie sie durch Umsetzung von epoxidierten Olefinen oder Poly- bzw. Diglycidylethern, wie Bisphenol-A-diglycidylether, mit (Meth)acrylsäure erhältlich sind.

Die Umsetzung ist dem Fachmann bekannt und z.B. in R. Holmann, U.V. and E.B. Curing Formulation for Printing Inks and Paints, London 1984, beschrieben.

Bei Urethan(meth)acrylaten handelt es sich insbesondere um Umsetzungsprodukte von Hydroxyalkyl(meth)acrylaten mit Poly- bzw. Diisocyanaten (s. ebenfalls R. Holmann, U.V. and E.B. Curing Formulation for Printing Inks and Paints, London 1984).

Es können natürlich auch Mischungen verschiedener Verbindungen a), insbesondere auch Mischungen der obigen (Meth)acrylverbindungen, eingesetzt werden.

Als Verbindungen a) kommen z.B. auch ungesättigte Polyesterharze in Betracht, welche im wesentlichen aus Polyolen, insbesondere Diolen, und Polycarbonsäuren, insbesondere Dicarbonsäuren, bestehen, wobei eine der Veresterungskomponenten eine copolymerisierbare, ethylenisch ungesättigte Gruppe enthält. Z.B. handelt es sich dabei um Maleinsäure, Fumarsäure oder Maleinsäureanhydrid.

Als strahlungshärtbare, radikalisch polymerisierbare Verbindungen kommen auch Verbindungen mit nur einer ethylenisch ungesättigten, copolymerisierbaren Gruppe in Betracht (Verbindungen b).

Genannt seien z.B. C₁-C₂₀-Alkyl (meth) acrylate, Vinylaromaten mit bis zu 20 C-Atomen, Vinylester von bis zu 20 C-Atomen enthaltenden Carbonsäuren, ethylenisch ungesättigten Nitrile, Vinylether von 1 bis 10 C-Atome enthaltenden Alkoholen und aliphatischen Kohlenwasserstoffen mit 2 bis 8 C-Atomen und 1 oder 2 Doppelbindungen.

Als (Meth)acrylsäurealkylester bevorzugt sind solche mit einem C₁-C₁₀-Alkylrest, wie Methylmethacrylat, Methylacrylat, n-Butylacrylat, Ethylacrylat und 2-Ethylhexylacrylat.

Insbesondere sich auch Mischungen der (Meth)acrylsäurealkylester geeignet.

Vinylester von Carbonsäuren mit 1 bis 20 C-Atomen sind z.B. Vinyllaurat, -stearat, Vinylpropionat und Vinylacetat.

Als vinylaromatische Verbindungen kommen z.B. Vinyltoluol, α-Butylstyrol, 4-n-Butylstyrol, 4-n-Decylstyrol und vorzugsweise Styrol in Betracht.

Beispiele für Nitrile sind Acrylnitril und Methacrylnitril.

Geeignete Vinylether sind z.B. Vinylmethylether, Vinylisobutylether, Vinylhexyl- und -octylether.

Als nicht aromatische Kohlenwasserstoffe mit 2 bis 8 C-Atomen und eine oder zwei olefinischen Doppelbindungen seien Butadien, Isopren, sowie Ethylen, Propylen und Isobutylen genannt.

Verbindungen b) werden vorzugsweise zusammen mit Verbindungen a) verwendet und dienen in Mengen von 0 bis 50 Gew.-%, vorzugsweise 0 bis 20 Gew.-%, bezogen auf die Gesamtmenge der strahlungshärtbaren, radikalisch polymerisierbaren Verbindung insbesondere als sogenannte Reaktivverdünner.

Erfindungsgemäß enthalten die strahlungshärtbaren Zusammensetzung α-Olefine mit mehr als 8 C-Atomen. (Diese α-Olefine werden bei allen Gewichts und Mengenangaben ebenfalls zu den strahlungshärtbaren, radikalisch polymerisierbaren Verbindungen gezählt).

Der Gehalt an den α-Olefinen beträgt 0,1 bis 10 Gew.-%, bevorzugt 0,1 bis 5 Gew.-%, bezogen auf die Gesamtmenge der strahlungshärtbaren, radikalisch polymerisierbaren Verbindung.

Die α-Olefine haben eine Kohlenstoff-Kohlenstoffdoppelbindung zwischen dem 1. und 2. Kohlenstoffatom der Kohlenstoffkette. Es handelt sich vorzugsweise um Monoolefine, d.h. vorzugsweise sind keine weiteren Doppelbindungen enthalten.

Vorzugsweise enthalten die α-Olefine mehr als 20, besonders bevorzugt mehr als 24, ganz besonders bevorzugt mehr als 26 C-Atome. Sehr gute Ergebnisse werden erzielt mit α-Olefinen mit 28 C-Atomen, insbesondere 30 C-Atomen und mehr.

Es eignen sich sehr langkettige α-Olefine für die strahlungshärtbaren Zusammensetzungen. Im allgemeinen sind α-Olefine mit bis zu 100, vorzugsweise bis zu 60 C-Atomen ausreichend.

Als α-Olefine genannt seien insbesondere:
Octacosa-1-en, Triaconta-1-en, Dotriaconta-1-en, Tetratriaconta-1-en, Hexatriaconta-1-en, Octatriaconta-1-en.

Die strahlungshärtbaren Zusammensetzungen können durch Mischen der α-Olefine mit den anderen Bestandteilen in beliebiger Reihenfolge hergestellt werden.

Insbesondere werden die α-Olefine zunächst zu den anderen strahlungshärtbaren Verbindungen gegeben und dann unter Temperaturerhöhung auf z.B. bis zu 80°C z.B. durch Rühren eingemischt. Die erhaltene Mischung wird dann nach Abkühlen filtriert.

Die erfindungsgemäßen Zusammensetzungen können noch weitere Zusatzstoffe enthalten. Zu erwähnen sind insbesondere hydrophobe Hilfsmittel, z.B. Petrolether oder höhersiedende Alkane oder Paraffine, welche die Wirkung des α-Olefine zur Verhinderung der Sauerstoffinhibierung verstärken können.

Die erfindungsgemäße Zusammensetzung kann darüber hinaus für die beabsichtigte Verwendung übliche Zusatzstoffe enthalten.

Bei der Verwendung als Beschichtungsmittel kann es sich dabei z.B. um Pigmente, Farbstoffe, Füllstoffe u.a. handeln.

Die strahlungshärtbaren Zusammensetzungen können durch UV-Licht oder Elektronenstrahlen radikalisch gehärtet werden.

Zur Strahlungshärtung durch UV-Licht werden üblicherweise Photoinitiatoren in Mengen von bis zu 5 Gew.-%, bezogen auf die strahlungshärtbaren, radikalisch polymerisierbaren Verbindungen zugesetzt.

Als Photoinitiatoren in Betracht kommen z.B. Benzophenon, Alkylbenzophenone, halogenmethylierte Benzophenone, Michlers Keton, Anthron und halogenierte Benzophenone. Ferner eignen sich Benzoin und seine Derivate. Ebenfalls wirksame Photoinitiatoren sind Anthrachinon und zahlreiche seiner Derivate, beispielsweise β-Methylanthrachinon, tert.-Butylanthrachinon und Anthrachinoncarbonsäureester und, besonders wirksam, Acylphosphinoxide, z.B. 2,4,6-Trimethylbenzoyldiphenylphosphinoxid (Lucirin® TPO).

Den erfindungsgemäßen Zusammensetzungen können auch noch Lösemittel zugesetzt werden, z.B. zur Einstellung der Verarbeitungsviskosität.

Geeignet sind z.B. Dimethylformamid, N-Methylpyrrolidon, Butylacetat, Methylpropylenglykolacetat und Diethylenglykoldimethylether.

Die erfindungsgemäßen Zusammensetzungen härten zu klebfreien Beschichtungen oder Formkörpern, welche gute mechanische Eigenschaften z.B. eine hohe Härte und gute elastische Eigenschaften aufweisen, und eine glänzende Oberfläche haben.

Eine Inhibierung durch Sauerstoff ist kaum zu beobachten, so daß auf Sauerstoffausschluß z.B. durch Schutzgase oder Abdeckungen mit Folien ganz oder zum Teil verzichtet werden kann.

### Beispiele

### 1. Beobachtung der Polymerisationsgeschwindigkeit durch IR Echtzeitspektroskopie

Bei der von Prof. Decker in J. Polym. Sei.: Part A:
Polymer Chemistry Band 30 (1992, Seite 913 beschriebenen Methode wird ein Überzug auf einem Kochsalzplättchen in einem IR Infrarotspektrometer mit UV-Licht gehärtet und gleichzeitig die Abnahme der Doppelbindungen, d.h. der Umsatz der Doppelbindungen, als Funktion der Zeit durch Infrarotspektroskopie beobachtet.

Der erreichte Umsatz bei den verschiedenen Proben nach 3 Sekunden Bestrahlung unter Luft ist nachfolgend angegeben. Die Proben enthielten 4 Gew.-%, Irgacure 500 als Photoinitiator. Bei Laromer® 8863 handelt es sich um ein Polyetheracrylat

| Probe | Umsatz |
|---|---|
| Laromer® 8863 | 15 % |
| Laromer 8863 mit 0,1 Gew.-% C₂₄-₂₈-α-Olefin | 30 % |
| Laromer 8863 mit 0,1 Gew.-% C₃₀-α-Olefin | 70 % |
| Laromer 8863 mit Folie abgedeckt | 70 % |

### 2. Anwendungstechnische Beispiele

Zu einem handelsüblichen Polyetheracrylat Laromer LR 8863 wurden 4 Gew.-% Photoinitiator Irgacure 500 und 0,1 % α-Olefin C 30 Plus von Chevron (Gulftene®) gegeben, mittels einer Kastenrakel auf einem Glasträger aufgebracht, auf ein Transportband gelegt und mit einer Bandgeschwindigkeit von 13 bzw. 60 oder 100 m/min unter einer UV-Lampe zur Aushärtung durchgeführt. Zum Vergleich wurden Paraffin und β-Olefine mit Laromer LR 8863 abgemischt.

Das Aussehen der gehärteten Beschichtung wurde beurteilt und die Pendelhärte nach DIN 53 157 in Sekunden (s) bestimmt.

| Zusatz zu Laromer 8863 | Bandgeschwindigkeit (m/min) | Pendelhärte (s) | Kratzfestigkeit ³ | Aussehen ⁴ |
|---|---|---|---|---|
| 0,1 % C₃₀-α-Olefin | 13 | 120 | + | + |
| | 60 | 121 | + | + |
| 1 % Paraffin ¹ | 13 | 140 | + | + |
| | 60 | 49 | - | - |
| 0,1 % C₃₀ α-Olefin + | 13 | 154 | + | + |
| 1 % Paraffin | 100 | 92 | + | +- |
| 1 % Glissopal ² | 13 | 104 | +- | - |
| | 60 | 91 | - | - |
| 0,1 % C₃₀-α-Olefin + | 13 | 154 | + | + |
| 5 % Petrolether | 100 | 95 | + | + |
| 0,1 % C₃₀-Alkanol | 60 | 50 | - | +- |

| | | | | |
|---|---|---|---|---|
| ¹ Paraffin mit Schmelzbereich von 56 bis 58°C | | | | |
| ² Polyisobutylen (ß-Olefin) | | | | |
| ³ kratzfest: + ; nicht kratzfest - | | | | |
| ⁴ glatte Oberfläche + ; Kraterbildung/Orangenhaut - | | | | |

## Patentansprüche

1. Strahlungshärtbare Zusammensetzungen auf Basis von strahlungshärtbaren, radikalisch polymerisierbaren Verbindungen, enthaltend 0,1 bis 10 Gew.-% α-Olefine mit mehr als 8 C-Atomen, bezogen auf die Gesamtmenge an radikalisch polymerisierbaren Verbindungen.

2. Strahlungshärtbare Zusammensetzungen gemäß Anspruch 1, wobei es sich um α-Olefine mit mehr als 24 C-Atomen handelt.

3. Strahlungshärtbare Zusammensetzungen gemäß Anspruch 1 oder 2, wobei es sich bei mindestens 50 Gew.-% der strahlungshärtbaren, radikalisch polymerisiserbaren Verbindungen um (Meth)acrylatverbindungen mit zwei oder mehr (Meth)acrylgruppen handelt.

4. Verfahren zur Herstellung von strahlungshärtbaren Zusammensetzungen mit verminderter Empfindlichkeit gegenüber Sauerstoff, dadurch gekennzeichnet, daß 0,1 bis 10 Gew.-% α-Olefine mit mehr als 8 C-Atomen, bezogen auf die Gesamtmenge an radikalisch polymerisierbaren Verbindungen, den strahlungshärtbaren Zusammensetzungen zugesetzt werden.

5. Verfahren zur Herstellung von Beschichtungen oder Formkörpern, dadurch gekennzeichnet, daß strahlungshärtbare Zusammensetzungen gemäß einem der Ansprüche 1 bis 3 mit energiereichem Licht bestrahlt werden.

6. Formkörper oder Beschichtungen, erhältlich durch das Verfahren gemäß Anspruch 5.

## Revendications

1. Compositions durcissables par rayonnement à base de composés durcissables par rayonnement, pouvant être polymérisés de façon radicalaire, contenant 0,1 à 10% en poids d'α-oléfines ayant plus de 8 atomes de carbone, par rapport à la quantité totale de composés pouvant être polymérisés de façon radicalaire.

2. Compositions durcissables par rayonnement selon la revendication 1, où les α-oléfines ont plus de 24 atomes de carbone.

3. Compositions durcissables par rayonnement selon la revendication 1 ou 2, où au moins 50% en poids des composés durcissables par rayonnement, pouvant être polymérisés de façon radicalaire, sont des composés (méth)acrylates ayant deux ou plusieurs groupements (méth)acrylate.

4. Procédé de préparation de compositions durcissables par rayonnement ayant une sensibilité réduite vis-à-vis de l'oxygène, caractérisé en ce que l'on ajoute à la composition durcissable par rayonnement, 0,1 à 10% en poids d'α-oléfines ayant plus de 8 atomes de carbone, par rapport à la quantité totale de composés pouvant être polymérisés de façon radicalaire.

5. Procédé de préparation de revêtements ou de corps moulés, caractérisé en ce que l'on irradie des compositions durcissables par rayonnement selon l'une quelconque des revendications 1 à 3 avec une lumière riche en énergie.

6. Corps moulés ou revêtements obtenus par le procédé selon la revendication 5.

## Claims

1. Radiation-curable compositions based on radiation-curable, free-radically polymerizable compounds, comprising from 0.1 to 10% by weight of α-olefins having more than 8 carbon atoms, based on the total amount of free-radically polymerizable compounds.

2. Radiation-curable compositions as claimed in claim 1, comprising α-olefins having more than 24 carbon atoms.

3. Radiation-curable compositions as claimed in claim 1 or 2, wherein not less than 50% by weight of the radiation-curable, free-radically polymerizable compounds are (meth)acrylate compounds having two or more (meth)acryloyl groups.

4. A process for preparing radiation-curable compositions having reduced sensitivity to oxygen, which comprises adding from 0.1 to 10% by weight of α-olefins having more than 8 carbon atoms, based on the total amount of free-radically polymerizable compounds, to the radiation-curable compositions.

5. A process for preparing coatings or moldings, which comprises irradiating radiation-curable compositions as claimed in any of claims 1 to 3 with high-energy light.

6. Moldings or coatings obtainable by the process of claim 5.
